# EUROPEAN PATENT APPLICATION

(11) **EP 4 811 943 A1**
(43) Date of publication of application: **23.09.2026**
(21) Application number: 24889940.3
(22) Date of filing: 14.03.2024
(51) Int. Cl.: H05K 7/20, H02M 7/42

(54) **INVERTER AND HEAT DISSIPATION STRUCTURE THEREOF**

(30) Priority: 16.11.2023 CN 202323132175 U
(71) Applicant: Sungrow Power Supply Co., Ltd., Hefei, Anhui 230088 (CN)
(72) Inventor: SHU, Wentao, Hefei, Anhui 230088 (CN); ZHENG, Hao, Hefei, Anhui 230088 (CN); WANG, Xiaohu, Hefei, Anhui 230088 (CN); ZHU, Qiyao, Hefei, Anhui 230088 (CN)
(74) Representative: Epping - Hermann - Fischer
(86) International application number: PCT/CN2024/081622
(87) International publication number: WO 2025/102566

(57) **Abstract**

The present application discloses an inverter and a heat dissipation structure thereof. The heat dissipation structure of the inverter comprises a first cabinet body and a second cabinet body. The first cabinet body comprises a heat dissipation cavity and an electronic cavity; the electronic cavity is used for accommodating an inverter power module part; the heat dissipation cavity is used for allowing air to flow through so as to cool a power module heat dissipation device; and the power module heat dissipation device is used for dissipating heat of a power module of the inverter power module part. The second cabinet body comprises a direct-current power distribution cavity and an alternating-current power distribution cavity; the direct-current power distribution cavity is used for accommodating a direct-current power distribution part; the alternating-current power distribution cavity is used for accommodating an alternating-current power distribution part; and at least one of the direct-current power distribution cavity and the alternating-current power distribution cavity is communicated with the electronic cavity to form a first circulating air duct. In the heat dissipation structure of the inverter, the heat dissipation of at least one of the direct-current power distribution part and the alternating-current power distribution part is coupled with the heat dissipation of the device in the electronic cavity, thereby reducing the heat dissipation cost.

## Description

The present application claims the priority to Chinese Patent Application No. 202323132175.1, titled "INVERTER AND HEAT DISSIPATION STRUCTURE THEREOF", filed on November 16, 2023 with the China National Intellectual Property Administration, which is incorporated herein by reference in its entirety.

### FIELD

The present application relates to the technical field of photovoltaic power generation and, in particular, to an inverter and a heat dissipation structure thereof.

### BACKGROUND

In grid-connected photovoltaic power generation systems, the inverter serves as the interface equipment connecting the photovoltaic power station to the power grid. The higher the power of the inverter, the lower the cost per watt, which is more conducive to achieving grid parity for photovoltaic power stations.

To enhance the power of the inverter, the components of the inverter are modularized to form multiple modular assemblies. These modular assemblies are independent of each other, and typically, each of the modular assemblies has its own independent heat dissipation system, which results in relatively high overall heat dissipation costs for the inverter.

At present, it is desired for those skilled in the art to design the heat dissipation arrangement for the modular assemblies of the inverter which can reduce the heat dissipation costs of the inverter.

### SUMMARY

In view of this, an object of the present application is to provide an inverter and a heat dissipation structure thereof, which can reduce heat dissipation costs of the inverter.

In order to achieve the above object, the following technical solutions are proposed according to the present application.

A heat dissipation structure for an inverter includes a first cabinet and a second cabinet.

The first cabinet includes a heat dissipation chamber and an electronic chamber. The electronic chamber is used to accommodate the inverter power module section, and the heat dissipation chamber is used for air to flow through to cool the power module radiator, which is used to dissipate heat from power modules of the inverter power module section.

The second cabinet includes a DC power distribution chamber and an AC power distribution chamber. The DC power distribution chamber is used to accommodate the DC power distribution section. The AC power distribution chamber is used to accommodate the AC power distribution section. At least one of the DC power distribution chamber and the AC power distribution chamber is in communication with the electronic chamber to form a first circulating air duct.

Optionally, the second cabinet further includes a filter reactor chamber, which is used to accommodate a reactor and allow passage of air to cool the reactor.

Optionally, the second cabinet further includes at least one first heat exchanger, which is used for enabling heat exchange between the air in the circulating air duct and the air flowing through the filter reactor chamber.

Optionally, at least one first heat exchanger is arranged between an air inlet of the filter reactor chamber and the reactor.

Optionally, the DC power distribution chamber includes a first DC sub-air duct and a second DC sub-air duct, with the first DC sub-air duct being closer to the electronic chamber than the second DC sub-air duct.

The AC power distribution chamber includes a first AC sub-air duct and a second AC sub-air duct, with the first AC sub-air duct being closer to the electronic chamber than the second AC sub-air duct.

The first DC sub-air duct forms part of the first circulating air duct, and the first AC sub-air duct forms part of the first circulating air duct.

Optionally, the second DC sub-air duct and the second AC sub-air duct are in communication to form a second circulating air duct.

At least one first heat exchanger is used for enabling heat exchange between the air in the second circulating air duct and the air flowing through the filter reactor chamber.

Optionally, the first circulating air duct and the second circulating air duct share a section of the air duct, and at least one first heat exchanger is located at the section shared by the first circulating air duct and the second circulating air duct.

Optionally, the electronic chamber, the DC power distribution chamber, and the AC power distribution chamber are sequentially connected end to end to form the first circulating air duct.

Optionally, the air duct in the DC power distribution chamber extends from a top end of the DC power distribution chamber to a bottom end of the DC power distribution chamber, and the air duct in the AC power distribution chamber extends from a top end of the AC power distribution chamber to a bottom end of the AC power distribution chamber.

Optionally, the bottom end of the DC power distribution chamber and the bottom end of the AC power distribution chamber are in communication through a first connecting channel, and the top end of the DC power distribution chamber or the top end of the AC power distribution chamber is in communication with the electronic chamber through a second connecting channel.

One of the first connecting channel and the second connecting channel is located between the air inlet of the filter reactor chamber and the reactor, and the other is located between the air outlet of the filter reactor chamber and the reactor.

Optionally, at least one first heat exchanger is arranged at the first connecting channel, and/or at least one first heat exchanger is arranged at the second connecting channel.

Optionally, the DC power distribution chamber includes a first DC sub-air duct and a second DC sub-air duct connected in parallel, and the AC power distribution chamber includes a first AC sub-air duct and a second AC sub-air duct connected in parallel.

The first DC sub-air duct is in communication with the first AC sub-air duct, and the second DC sub-air duct is in communication with the second AC sub-air duct.

Optionally, between the top end and the bottom end of the DC power distribution chamber and between the top end and the bottom end of the AC power distribution chamber, the first DC sub-air duct is communicated with the first AC sub-air duct, and the second DC sub-air duct is communicated with the second AC sub-air duct.

The second DC sub-air duct passes through the bottom end of the DC power distribution chamber, and the second AC sub-air duct passes through the bottom end of the AC power distribution chamber.

Optionally, the first DC sub-air duct and the first AC sub-air duct, as well as the second DC sub-air duct and the second AC sub-air duct, are in communication through a common first connecting channel. Alternatively, the first DC sub-air duct and the first AC sub-air duct, as well as the second DC sub-air duct and the second AC sub-air duct, are in communication through different first connecting channels.

The top end of the DC power distribution chamber or the top end of the AC power distribution chamber is in communication with the electronic chamber through a second connecting channel.

The air inlet of the filter reactor chamber, the second connecting channel, the first connecting channel, and the reactor are sequentially distributed along the direction of airflow in the filter reactor chamber.

Optionally, at least one first heat exchanger is arranged at each first connecting channel, and/or at least one first heat exchanger is arranged at the second connecting channel.

Optionally, the first DC sub-air duct and the first AC sub-air duct are in communication between the top end and the bottom end of the DC power distribution chamber and between the top end and the bottom end of the AC power distribution chamber.

The second DC sub-air duct and the second AC sub-air duct are in communication at the bottom end of the DC power distribution chamber and at the bottom end of the AC power distribution chamber.

Optionally, the first DC sub-air duct and the first AC sub-air duct are in communication through a first connecting channel, and the second DC sub-air duct and the second AC sub-air duct are in communication through a third connecting channel.

The DC power distribution chamber or the AC power distribution chamber is in communication with the electronic chamber through a second connecting channel.

The air inlet of the filter reactor chamber, the second connecting channel, the first connecting channel, the reactor, and the third connecting channel are sequentially distributed along the direction of airflow in the filter reactor chamber.

Optionally, the at least one first heat exchanger is arranged at each first connecting channel, and/or the at least one first heat exchanger is arranged at the third connecting channel, and/or the at least one first heat exchanger is arranged at the second connecting channel.

Optionally, one of the DC power distribution chamber and the AC power distribution chamber is in communication with the electronic chamber to form a first circulating air duct, and the other is not in communication with the electronic chamber.

The second cabinet is provided with a fourth connecting channel and a fifth connecting channel. One of the DC power distribution chamber and the AC power distribution chamber that is in communication with the electronic chamber, the fourth connecting channel, the electronic chamber, and the fifth connecting channel are sequentially connected end to end to form the first circulating air duct.

Optionally, the at least first heat exchanger is arranged at the fourth connecting channel; and/or, the at least first heat exchanger is arranged at the fifth connecting channel.

Optionally, the second cabinet is provided with a second heat exchanger, which has a first channel and a second channel for heat exchange. One of the DC power distribution chamber and the AC power distribution chamber, which is not in communication with the electronic chamber, is in communication with the first channel. The second channel is used for air to flow through.

Optionally, the air inlet and the air outlet of the heat dissipation chamber are located on different sides of the first cabinet, and the air inlet and the air outlet of the filter reactor chamber are located on different sides of the second cabinet. The first cabinet and the second cabinet are referred to as a cabinet. The air outlet of the filter reactor chamber and the air inlet of the heat dissipation chamber are located on different sides of the cabinet, and the air outlet of the heat dissipation chamber and the air inlet of the filter reactor chamber are located on different sides of the cabinet.

Additionally/alternatively, the DC power distribution chamber and the AC power distribution chamber are distributed on opposite sides of the filter reactor chamber.

Additionally/alternatively, both the DC power distribution chamber and the AC power distribution chamber are relatively isolated from the filter reactor chamber.

Optionally, the first cabinet is provided with a third heat exchanger, which has a first channel and a second channel for heat exchange. The first channel is in communication with the heat dissipation chamber, and the second channel is in communication with the electronic chamber.

Additionally/alternatively, the heat dissipation chamber and the electronic chamber are relatively isolated, and the first circulating air duct is a closed air duct.

Additionally/alternatively, the electronic chamber is further used to accommodate a control circuit section.

Additionally/alternatively, the first cabinet and the second cabinet are sequentially distributed in a vertical direction.

Based on the above heat dissipation structure for the inverter, an inverter is further provided according to the present application. The inverter includes the heat dissipation structure for the inverter as described above.

In the heat dissipation structure for the inverter provided in the present application, by dividing the first cabinet into a heat dissipation chamber and an electronic chamber and using the heat dissipation chamber to dissipate heat from the power module radiator, forced air cooling heat dissipation may be achieved, thus effectively improving the heat dissipation efficiency of the power modules, ensuring the protection requirements of devices in the electronic chamber, and providing a prerequisite for the heat dissipation coupling between the electronic chamber and other chambers (the DC power distribution chamber and/or the AC power distribution chamber). At the same time, the second cabinet includes a DC power distribution chamber and an AC power distribution chamber, and at least one of the DC power distribution chamber and the AC power distribution chamber is in communication with the electronic chamber to form a circulating air duct, achieving the heat dissipation coupling between the devices in the electronic chamber and at least one of the DC power distribution section and the AC power distribution section. In this way, heat dissipation costs are reduced, compared with the separate heat dissipation of the first cabinet and the second cabinet (independent heat dissipation of each modular assembly) in the conventional technology.

### BRIEF DESCRIPTION OF THE DRAWINGS

In order to describe the technical solutions in the embodiments of the present application or in the conventional technology more clearly, the drawings for describing the embodiments or the conventional technology are briefly introduced hereinafter. Apparently, the drawings in the following description show merely the embodiments of the present application, and those skilled in the art can obtain other drawings based on these drawings without creative efforts.
FIG. 1 is a schematic structural view of a heat dissipation structure of an inverter according to a first embodiment of the present application;
FIG. 2 is a side view of the structure shown in FIG. 1;
FIG. 3 shows an airflow within a heat dissipation chamber in the heat dissipation structure of the inverter according to the first embodiment of the present application;
FIG. 4 shows another airflow within the heat dissipation chamber in the heat dissipation structure of the inverter according to the first embodiment of the present application;
FIG. 5 shows another airflow within the heat dissipation chamber in the heat dissipation structure of the inverter according to the first embodiment of the present application;
FIG. 6 shows another airflow within the heat dissipation chamber in the heat dissipation structure of the inverter according to the first embodiment of the present application;
FIG. 7 shows another airflow within the heat dissipation chamber in the heat dissipation structure of the inverter according to the first embodiment of the present application;
FIG. 8 shows another airflow within the heat dissipation chamber in the heat dissipation structure of the inverter according to the first embodiment of the present application;
FIG. 9 shows another airflow within the heat dissipation chamber in the heat dissipation structure of the inverter according to the first embodiment of the present application;
FIG. 10 shows an airflow within a filter reactor chamber in the heat dissipation structure of the inverter according to the first embodiment of the present application;
FIG. 11 is a schematic structural view of a heat dissipation structure of an inverter according to a second embodiment of the present application;
FIG. 12 is a side view of the structure shown in FIG. 11;
FIG. 13 is a schematic structural view of variation of the heat dissipation structure of the inverter according to the second embodiment of the present application;
FIG. 14 is a schematic structural view of variation of the heat dissipation structure of the inverter according to the second embodiment of the present application;
FIG. 15 is a schematic structural view of a heat dissipation structure of an inverter according to a third embodiment of the present application;
FIG. 16 is a side view of the structure shown in FIG. 15;
FIG. 17 is a schematic structural view of variation of the heat dissipation structure of the inverter according to the third embodiment of the present application;
FIG. 18 is a side view of the structure shown in FIG. 17;
FIG. 19 is a schematic structural view of variation of the heat dissipation structure of the inverter according to the third embodiment of the present application;
FIG. 20 is a schematic structural view of variation of the heat dissipation structure of the inverter according to the third embodiment of the present application;
FIG. 21 is a schematic structural view of a heat dissipation structure of an inverter according to a fourth embodiment of the present application;
FIG. 22 is a schematic structural view of a heat dissipation structure of an inverter according to a fifth embodiment of the present application;
FIG. 23 is a side view of the structure shown in FIG. 12; and
FIG. 24 is a schematic structural view of an air-to-air heat exchanger in a heat dissipation structure of an inverter according to an embodiment of the present application.

**Description of reference numerals in the drawings:**

| | | | |
|---|---|---|---|
| 100 | first cabinet, | 200 | second cabinet, |
| 101 | heat dissipation chamber, | 102 | electronic chamber, |
| 103 | first air inlet, | 104 | first air outlet, |
| 105 | second air inlet, | 201 | DC power distribution chamber, |
| 2011 | first DC sub-air duct, | 2012 | second DC sub-air duct, |
| 202 | AC power distribution chamber, | 2021 | first AC sub-air duct, |
| 2022 | second AC sub-air duct, | 203 | filter reactor chamber, |
| 204 | third air inlet, | 205 | third air outlet, |
| 1 | third fan, | 2 | DCpower distribution section, |
| 3 | AC power distribution section, | 4 | reactor, |
| 5 | first connecting channel, | 6 | second connecting channel, |
| 7 | second fan, | 8 | fourth fan, |
| 9 | fifth fan, | 10 | first fan, |
| 11 | power module radiator, | 12 | first partition plate, |
| 13 | second partition plate, | 14 | sixth fan, |
| 15 | seventh fan, | 16 | third connecting channel, |
| 17 | fifth connecting channel, | 18 | third partition plate, |
| 19 | fourth connecting channel, | 20 | third heat exchanger, |
| 21 | eighth fan, | 01 | first heat exchange channel, |
| 02 | second heat exchange channel. | | |

### DETAILED DESCRIPTION OF THE EMBODIMENTS

Hereinafter, technical solutions in embodiments of the present application will be described clearly and completely with reference to the drawings showing the embodiments of the present application. Apparently, the described embodiments are only some rather than all embodiments of the present application. Based on the embodiments of the present application, all other embodiments obtained by those skilled in the art without any creative work fall into the protection scope of the present application.

Technical solutions according to embodiments of the present application will be described clearly and completely as follows with reference to the accompany drawings showing the embodiments of the present application. The terminologies used in the following embodiments are only for the purpose of describing specific embodiments, and are not intended to limit the present application. As used in the specification and appended claims of the present application, the singular expressions "a", "one", "said", "the above", "the" and "this" are intended to include expressions such as "one or more", unless otherwise indicated clearly in the context. It should also be understood that, in the embodiment of the present application, the expression "one or more" refers to one, two or more; the expression "and/or" describes an association relationship of related objects and indicates three possible relationships. For example, A and/or B may indicate three cases: A alone, A and B, and B alone. In each case, the number of A may be one or more, and the number of B may be one or more. The symbol "/" generally indicates an "or" relationship between the objects it connects.

In this specification, references to "an embodiment", "some embodiments" or the like mean that a particular feature, structure, or characteristic described in connection with the embodiment(s) is included in one or more embodiments of the present application. Thus, phrases such as "in an embodiment", "in some embodiments", "in some other embodiments" and "in yet other embodiments" etc., appearing in different places in this specification do not necessarily all refer to the same embodiment(s). Rather, they mean "one or more, but not all embodiments" unless otherwise specifically emphasized. The terms "comprising", "including", "having" and variations thereof mean "including, but not limited to" unless otherwise specifically emphasized.

The term "multiple or a plurality of" in the embodiment of the present application refers to two or more. It should be noted that, in the description of the embodiments of the present application, words such as "first" and "second" are only used for the purpose of distinguishing descriptions, and cannot be understood as indicating or implying relative importance, nor can they be understood as indicating or implying order.

An inverter mainly includes a DC power distribution section, an inverter power module section, an AC filtering section, an AC power distribution section, a control circuit section, etc.

In the inverter, both the inverter power module section and the control circuit section may be considered as part of a first modular assembly, and the DC power distribution section, the AC filtering section, and the AC power distribution section may be considered as part of a second modular assembly. The first modular assembly is typically arranged in the first cabinet, and the second modular assembly is arranged in the second cabinet, with the first and second cabinets being relatively independent.

It should be noted that both the first and second modular assemblies may be used independently and may be interchanged between different inverters, and may also be used outdoors, if necessary. The inverter may further include other modular assemblies, and be not limited to the first and second modular assemblies mentioned above.

The first and second cabinets dissipate heat independently, meaning that the first and second modular assemblies dissipate heat independently, resulting in high overall heat dissipation costs for the inverter.

In view of the aforementioned issues, an inverter and a heat dissipation structure thereof are provided according to embodiments of the present application, which can reduce the heat dissipation costs of the inverter.

Based on the functions, physical dimensions, heat generation characteristics, and inherent protection levels of the various components of the inverter (the DC power distribution section, the inverter power module section, the AC filtering section, the AC power distribution section, and the control circuit section), the heat dissipation structure of the inverter is reasonably designed and optimized. Four embodiments are provided below to specifically illustrate the heat dissipation structure of the inverter provided according to the embodiments of the present application.

### First Embodiment

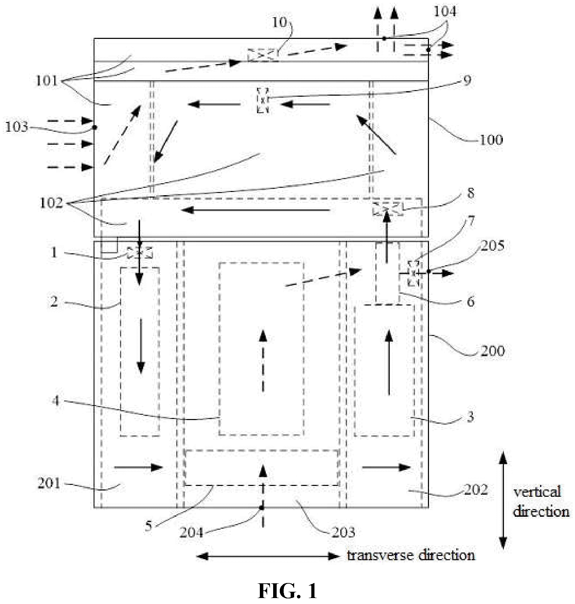

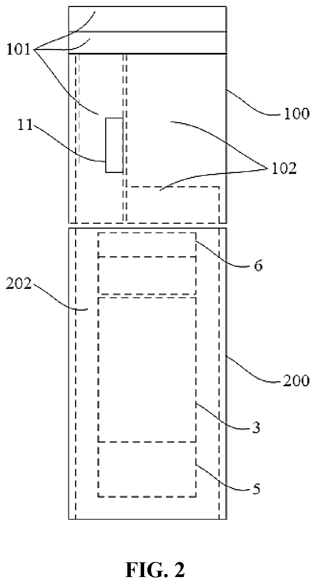

As shown in FIGS.1 and 2, the heat dissipation structure of the inverter provided according to the first embodiment includes a first cabinet 100 and a second cabinet 200.

In this embodiment, the first cabinet 100 is located at the top of the second cabinet 200. It can be understood that the first cabinet 100 and the second cabinet 200 are sequentially distributed from top to bottom in a vertical direction.

The first cabinet 100 and the second cabinet 200 may be sequentially distributed from bottom to top in the vertical direction. Alternatively, the first cabinet 100 and the second cabinet 200 may be sequentially distributed in any other direction, and be not limited to the vertical direction.

The first cabinet 100 includes a heat dissipation chamber 101 and an electronic chamber 102. The heat dissipation chamber 101 and the electronic chamber 102 may be arranged based on actual circumstances, which is not limited in the first embodiment.

The electronic chamber 102 is used to accommodate components such as the inverter power module section and the control circuit section. This facilitates the connection between the components. It can be understood that the inverter power module section includes an inverter module. It should be noted that the components in the electronic chamber 102 are not shown in FIGS. 1 and 2. The control circuit section may also be placed in any other location, for example, in the second cabinet 200, which is not limited in this embodiment.

The power modules in the inverter power module section generate a large amount of heat, and the heat is relatively concentrated. To meet the heat dissipation requirements of the power modules, a power module radiator 11 is used to dissipate heat from the power modules, that is, the power module radiator 11 cools the power modules.

The functional module radiator 11 may be an air-cooled radiator. The power module radiator 11 includes a heat dissipation base plate and heat dissipation fins disposed on the heat dissipation base plate. The functional module is arranged on the heat dissipation base plate, and the heat from the functional module is transferred to the heat dissipation base plate, and then dissipated through the heat dissipation fins.

The power module radiator 11 may be a liquid-cooled radiator, on which the power module is arranged. In this case, the first cabinet 100 needs to be provided with a liquid cooling system. The liquid cooling system is communicated with the liquid-cooled radiator and is used to cool the coolant in the liquid-cooled radiator. The coolant may be water or any other liquid, which is not limited in this embodiment.

The liquid cooling system mainly includes a liquid cooling heat exchanger and a circulation pump that drives the coolant to circulate between the liquid cooling heat exchanger and the liquid-cooled radiator.

Certainly, the power module radiator 11 may be of any other type, and be not limited to the two types mentioned above.

The heat dissipation chamber 101 is used for air to flow through to cool the power module radiator 11. The air entering the heat dissipation chamber 101 may be air coming from the outside of the heat dissipation chamber 101, e.g., air coming from the outside of the entire inverter or air coming from a chamber of the inverter other than the heat dissipation chamber 101.

In FIG. 1, the dashed arrows in the first cabinet 100 indicate the direction of airflow in the heat dissipation chamber 101. The direction indicated by these dashed arrows is only an approximate and illustrative direction, which is not absolute.

To improve the protection level of the electronic chamber 102, the heat dissipation chamber 101 and the electronic chamber 102 may be relatively isolated, thereby allowing different protection levels for the heat dissipation chamber 101 and the electronic chamber 102, with the protection level of the electronic chamber 102 being higher than that of the heat dissipation chamber 101. The heat dissipation chamber 101 may be referred to as a low-protection chamber, and the electronic chamber 102 may be referred to as a high-protection chamber.

The power module radiator 11 may be arranged in the heat dissipation chamber 101 or the electronic chamber 102. To facilitate maintenance of the power module radiator 11 and to improve the protection level of the electronic chamber 102, the power module radiator 11 may be disposed in the heat dissipation chamber 101.

For example, if the power module radiator 11 is an air-cooled radiator, the heat dissipation fins of the power module radiator 11 are located in the heat dissipation chamber 101, and the air flowing through the heat dissipation chamber 101 flows over the heat dissipation fins, thereby cooling the power module radiator 11. In this case, the entire power module radiator 11 may be arranged in the heat dissipation chamber 101, or only part (the heat dissipation fins) of the power module radiator 11 may be located in the heat dissipation chamber 101.

For example, the power module radiator 11 is a liquid-cooled radiator. The liquid cooling heat exchanger of the liquid cooling system is arranged in the heat dissipation chamber 101, so that the air flowing through the heat dissipation chamber 101 flows through the liquid cooling heat exchanger to cool the coolant in the liquid cooling heat exchanger, thereby cooling the coolant in the liquid-cooled radiator, i.e., achieving the cooling of the power module radiator. In this case, the entire power module radiator 11 may be arranged in the heat dissipation chamber 101 or the electronic chamber 102; or part of the power module radiator 11 may be located in the heat dissipation chamber 101 and the other part in the electronic chamber 102. The liquid cooling heat exchanger and the circulation pump may both be arranged in the heat dissipation chamber 101.

In the above structure, the power modules may be cooled through forced air cooling process or forced liquid cooling process, improving heat dissipation efficiency. Furthermore, the first cabinet 100 is divided into a heat dissipation chamber 101 and an electronic chamber 102, and the heat dissipation chamber 101 is used to dissipate heat from the power module radiator 11. In this way, forced air cooling can be achieved, thus effectively improving heat dissipation efficiency, ensuring the protection requirements of the components within the electronic chamber 102, and providing a prerequisite for the heat dissipation coupling between the electronic chamber 102 and other chambers (the DC power distribution chamber 201 and/or the AC power distribution chamber 202).

The heat dissipation chamber 101 has an air inlet and an air outlet. In this embodiment, the air inlet of the heat dissipation chamber 101 includes a first air inlet 103, and the air outlet of the heat dissipation chamber 101 includes a first air outlet 104.

For example, as shown in FIG.1, there is a single first air inlet 103 and two first air outlets 104. The first air inlet 103 is located on the front side of the first cabinet 100. One of the first air outlets 104 is located on the rear side of the first cabinet 100, and the first air inlet 103 is lower than this first air outlet 104. The other one of the first air outlets 104 is located on the top side of the first cabinet 100 and is close to the rear side of the first cabinet 100.

It should be noted that the front side and the rear side of the first cabinet 100 are opposite to each other, and both the front side and the rear side of the first cabinet 100 are provided with cabinet doors. The front side and the rear side of the first cabinet 100 are the two sides of the first cabinet 100 in its transverse direction.

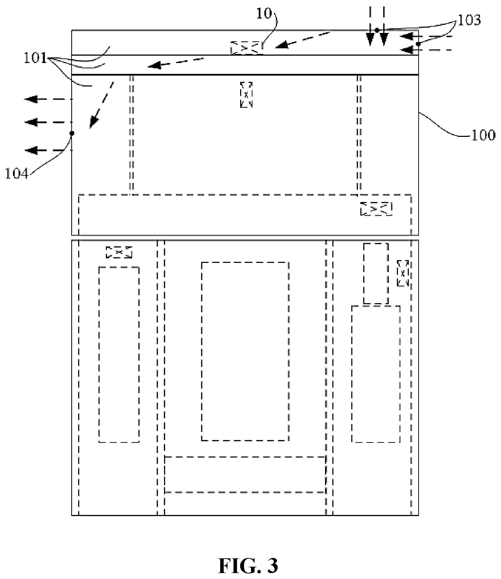

The positions of the first air inlet 103 and the first air outlet 104 in FIG. 1 may be interchanged, and accordingly, the number of the first air inlet 103 and the first air outlet 104 may also be interchanged. The structure after interchange is shown in FIG. 3.

It should be noted that, if the air inlet or the air outlet of the heat dissipation chamber 101 is distributed on the top side of the first cabinet 100, the IP protection level requirement for the first fan 10 is relatively high. In actual situations, the positions and number of the first air inlet 103 and the first air outlet 104 may be adjusted based on heat dissipation requirements.

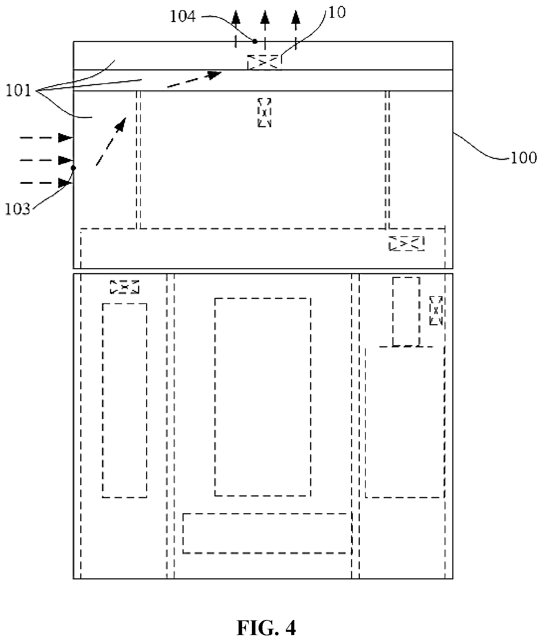

As shown in FIG. 4, in some embodiments, the first air outlet 104 is only provided on the top side of the first cabinet 100. For example, the first air outlet 104 is arranged in the middle of the top side of the first cabinet 100. In this case, the first air inlet 103 is provided on the front side and/or the rear side of the first cabinet 100.

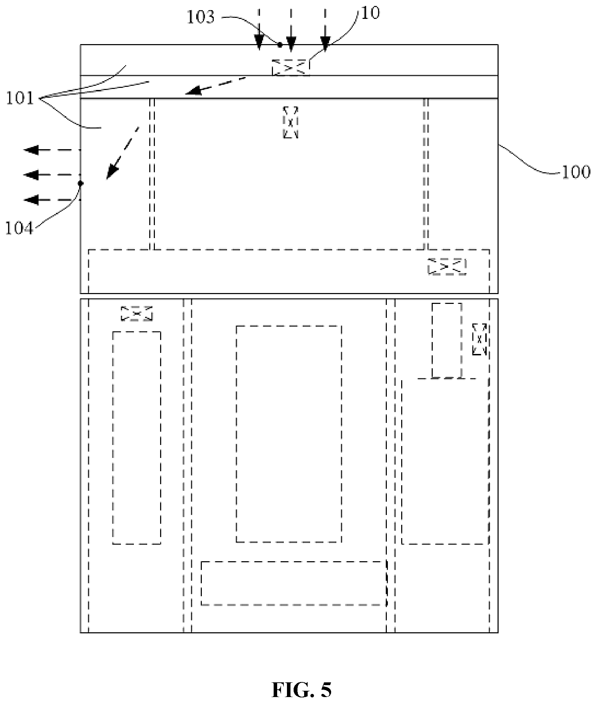

The positions of the first air inlet 103 and the first air outlet 104 in FIG. 4 may be interchanged, and the structure after interchange is shown in FIG. 5.

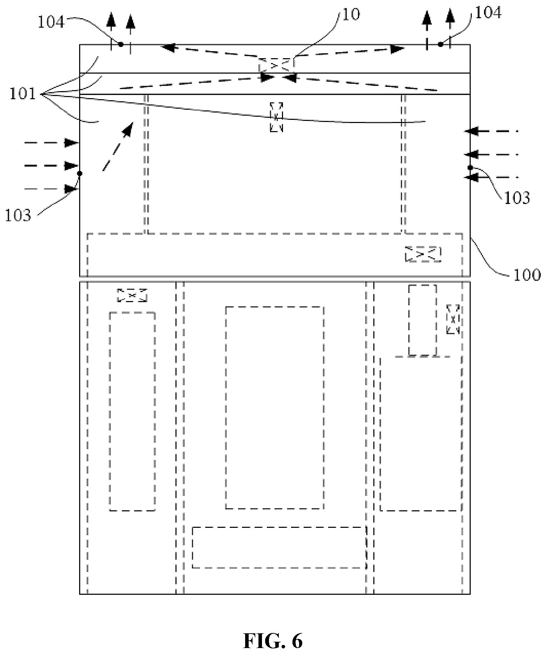

As shown in FIG. 6, in some embodiments, one first air inlet 103 is located on the front side of the first cabinet 100, and the other first air inlet 103 is located on the rear side of the first cabinet 100. Both of the first air outlets 104 are located on the top side of the first cabinet 100, with one first air outlet 104 positioned near the front side and the other near the rear side of the first cabinet 100. In this way, both the air inlets and air outlets of the heat dissipation chamber 101 are increased in number, effectively improving the ventilation volume of the heat dissipation chamber 101, which is conducive to enhancing the heat dissipation effect and efficiency.

It should be noted that the number of first air inlets 103 and first air outlets 104 in the above embodiment may be adjusted based on actual conditions, which is not limited to two first air inlets 103 and two first air outlets 104.

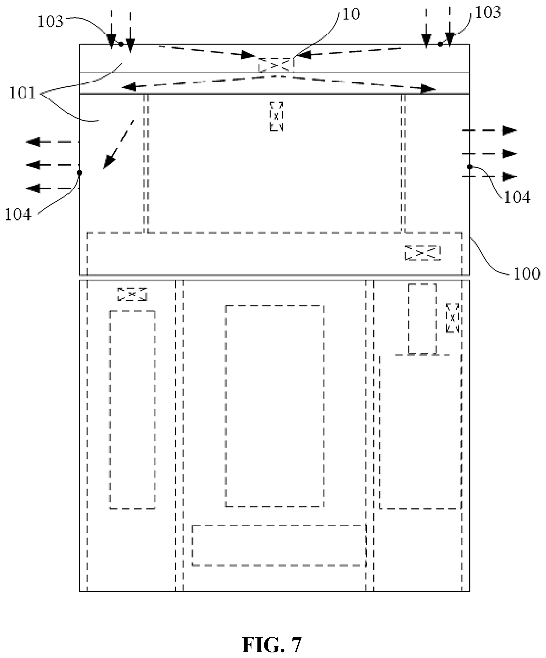

The positions of the first air inlet 103 and the first air outlet 104 in FIG. 6 may be interchanged, and the structure after interchange is shown in FIG. 7.

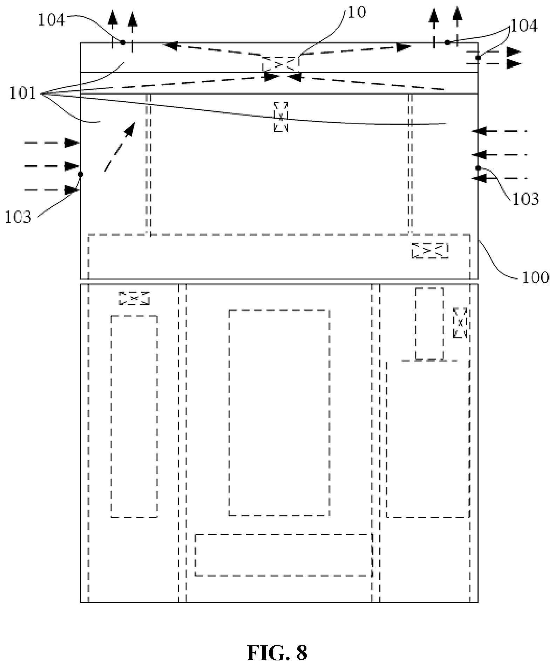

In the above embodiments, the first air outlets 104 may be additionally provided at other positions. As shown in FIG. 8, based on the structure shown in FIG. 6, at least one additional first air outlet 104 is provided, and the added first air outlet 104 is located on the rear side of the first cabinet 100.

It should be noted that the positions of the first air inlet 103 and the first air outlet 104 in the air intake mode shown in FIG. 8 may be interchanged.

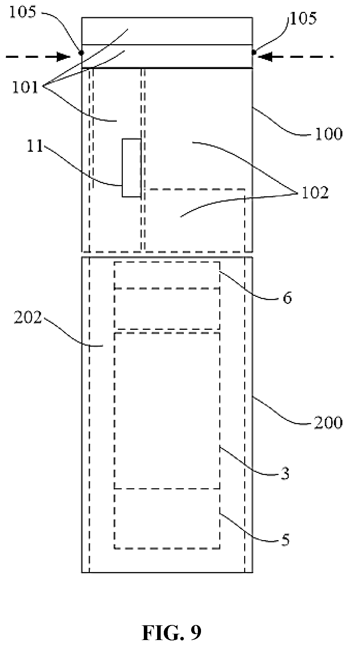

The air inlets and the air outlets of the heat dissipation chamber 101 may be provided at other positions, which are not limited to the left side, the right side, and the top mentioned earlier. As shown in FIG. 9, in some embodiments, the heat dissipation chamber 101 further includes second air inlets 105, which are located on the left and right sides of the first cabinet 100. It can be understood that the second air inlet 105 and the first air inlet 103 are located on different sides of the first cabinet 100. In this way, the air intake volume of the heat dissipation chamber 101 is effectively increased, which is conducive to improving the heat dissipation effect and efficiency.

The second air inlets 105 may be provided only on the left side or the right side of the first cabinet 100 and are not limited to the air intake mode shown in FIG. 9.

In some other embodiments, the heat dissipation chamber 101 may further include a second air outlet (not shown), which is located on the left and/or right side of the first cabinet 100, and the second air outlet and the first air outlet 104 are located on different sides of the first cabinet 100. In this way, the air outlet volume of the heat dissipation chamber 101 is effectively increased, which is conducive to improving the heat dissipation effect and efficiency.

It should be noted that the position of the second air outlet is the same as the position of the second air inlet 105 shown in FIG. 9.

In some other embodiments, the heat dissipation chamber 101may only include the second air inlet 105, or the heat dissipation chamber 101 may only include the second air outlet, which is not limited to the above-mentioned embodiments.

In some embodiments, to avoid mutual interference between the air inlet and air outlet of the heat dissipation chamber 101, the air inlets and the air outlets of the heat dissipation chamber 101 may be located on different sides of the first cabinet 100, as shown in FIGS. 1, 3 to 7. Alternatively, it is possible to arrange at least one air inlet and at least one air outlet of the heat dissipation chamber 101 on the same side of the first cabinet 100.

In actual situations, the positions and number of the air inlets and the air outlets of the heat dissipation chamber 101 may be determined depending on actual conditions, which is not limited in the first embodiment.

To facilitate the flow of air through the heat dissipation chamber 101, a first fan 10 is provided inside the heat dissipation chamber 101. The specific position of the first fan 10 may be determined depending on actual conditions, which is not limited in this first embodiment.

For ease of maintenance, the first fan 10 may be arranged at the top of the heat dissipation chamber 101. For example, the first fan 10 is located at the top of the heat dissipation chamber 101 near the front side, or the first fan 10 is located at the top of the heat dissipation chamber 101 near the rear side, or the first fan 10 is located at the top of the heat dissipation chamber 101 in the middle position between the front and rear sides.

As shown in FIG. 1, the second cabinet 200 includes a DC power distribution chamber 201, an AC power distribution chamber 202, and a filter reactor chamber 203. The DC power distribution chamber 201 is used to accommodate the DC power distribution section 2; the AC power distribution chamber 202 is used to accommodate the AC power distribution section 3; and the filter reactor chamber 203 is used to accommodate the reactor 4.

The DC power distribution chamber 201 and AC power distribution chamber 202 are respectively located on both sides of the filter reactor chamber 203, that is, the filter reactor chamber 203 is located between the DC power distribution chamber 201 and the AC power distribution chamber 202. The positions of the DC power distribution chamber 201 and the AC power distribution chamber 202 may be interchanged.

Alternatively, it is possible to arrange the DC power distribution chamber 201 and the AC power distribution chamber 202 on the same side of the filter reactor chamber 203. For example, in FIG. 1, both the DC power distribution chamber 201 and the AC power distribution chamber 202 are located on the left side of the filter reactor chamber 203, and the DC power distribution chamber 201 and the AC power distribution chamber 202 may be arranged sequentially either in the transverse direction or in the longitudinal direction. The transverse and longitudinal directions are perpendicular to each other, and the transverse and longitudinal directions both are perpendicular to the vertical direction, which is the height direction of the second cabinet 200.

The reactor in the inverter generates a large amount of heat and the heat is relatively concentrated. Since the reactor 4 has a relatively high protection level, the reactor 4 may be in direct contact with the air outside the filter reactor chamber 203. To this end, the filter reactor chamber 203 is configured for air to flow through to cool the reactor 4. The air entering the filter reactor chamber 203 may be the air outside the filter reactor chamber 203, for example, the air outside the entire inverter or the air in a chamber of the inverter other than the filter reactor chamber 203.

In the above structure, the reactor 4 is forced to dissipate heat by a large volume of cold air. The filter reactor chamber 203 has an air inlet and an air outlet. In this embodiment, the filter reactor chamber 203 includes a third air inlet 204, and the filter reactor chamber 203 includes a third air outlet 205.

The third air inlet 204 is located at the bottom end of the filter reactor chamber 203, and the third air outlet 205 is located on one side of the filter reactor chamber 203 near the top. For example, the third air outlet 205 is located on the top of the filter reactor chamber 203 near the AC power distribution chamber 202. Alternatively, the third air outlet 205 may be provided on the top of the filter reactor chamber 203 near the DC power distribution chamber 201. The positions of the third air inlet 204 and the third air outlet 205 may be interchanged.

It should be noted that the dashed arrows in the second cabinet 200 in FIG. 1 indicate the direction of airflow in the filter reactor chamber 203, and the direction shown by the dashed arrows is only an approximate and schematic direction and is not absolute.

To prevent the mutual interference between the air inlet and outlet of the filter reactor chamber 203, the air inlets and the air outlets of the filter reactor chamber 203 are located on different sides of the second cabinet 200 respectively. Alternatively, the air inlets and the air outlets of the filter reactor chamber 203 may be arranged on the same side of the second cabinet 200, which is not limited to the above structure.

To facilitate passage of airflow through the filter reactor chamber 203, the filter reactor chamber 203 is provided with a second fan 7. The position of the second fan 7 may be determined based on actual conditions. For example, the second fan 7 may be located at or near the third air inlet 204, or located at or near the third air outlet 205, which is not limit in this first embodiment.

Air is required to flow in or out from each of the heat dissipation chamber 101 and the filter reactor chamber 203. To prevent mutual interference between the heat dissipation chamber 101 and the filter reactor chamber 203, the air outlet of the heat dissipation chamber 101 and the air inlet of the filter reactor chamber 203 may be located on different sides of a cabinet (the first cabinet 100 and the second cabinet 200 may be referred to as a cabinet). Additionally, the air outlet of the filter reactor chamber 203 and the air inlet of the heat dissipation chamber 101 may be located on different sides of the cabinet.

In the above structure, the air inlet of the heat dissipation chamber 101 and the air inlet of the filter reactor chamber 203 may be located on the same side of the cabinet, or may be located on different sides of the cabinet respectively. Similarly, the air outlet of the heat dissipation chamber 101 and the air outlet of the filter reactor chamber 203 may be located on the same side of the cabinet, or may be located on different sides of the cabinet respectively.

If there is no need to consider the mutual interference between the heat dissipation chamber 101 and the filter reactor chamber 203, the air outlet of the heat dissipation chamber 101 and the air inlet of the filter reactor chamber 203 may be located on the same side of the cabinet, and/or the air outlet of the filter reactor chamber 203 and the air inlet of the heat dissipation chamber 101 may be located on the same side of the cabinet.

In practical situations, the reactor 4 may be cooled in any other manner, which is not limited to the air cooling mentioned above.

There is a case that the components in the DC power distribution section 2 and the AC power distribution section 3 have relatively low protection levels. To improve the protection levels of the DC power distribution section 2 and the AC power distribution section 3, the DC power distribution chamber 201 may be relatively isolated from the filter reactor chamber 203, so that the protection levels of the DC power distribution chamber 201 and the filter reactor chamber 203 may be different, and the protection level of the DC power distribution chamber 201 may be higher than that of the filter reactor chamber 203. Similarly, the AC power distribution chamber 202 may be relatively isolated from the filter reactor chamber 203, so that the protection levels of the AC power distribution chamber 202 and the filter reactor chamber 203 may be different, and the protection level of the AC power distribution chamber 202 may be higher than that of the filter reactor chamber 203. Here, the filter reactor chamber 203 may be referred to as a low-protection chamber, while both the DC power distribution chamber 201 and the AC power distribution chamber 202 may be referred to as high-protection chambers.

Given that the electronic chamber 102, the DC power distribution chamber 201, and the AC power distribution chamber 202 are all high-protection chambers, the DC power distribution chamber 201 may be in communication with the electronic chamber 102, and the AC power distribution chamber 202 may be in communication with the electronic chamber 102. Moreover, the DC power distribution chamber 201 and the AC power distribution chamber 202 are in communication through a first connecting channel 5. In this way, the DC power distribution chamber 201, the first connecting channel 5, the AC power distribution chamber 202, and the electronic chamber 102 are sequentially connected end to end, forming a first circulating air duct. The entire DC power distribution chamber 201 may form part of the first circulating air duct, and the entire AC power distribution chamber 202 may form another part of the first circulating air duct. To enhance heat dissipation effects, the first circulating air duct may be configured to be a closed air duct, that is, the first circulating air duct is not in communication with the outside. In practical situations, the first circulating air duct may be in communication with the external environment, as long as it does not affect the flow of air within the first circulating air duct in the predetermined direction.

It should be noted that the solid arrows in FIG. 1 indicate the direction of airflow in the first circulating air duct. The direction shown by these solid arrows is only an approximate and schematic representation, not absolute.

In the above structure, the heat dissipation of the DC power distribution section 2 is coupled with that of the components in the electronic chamber 102, and the heat dissipation of the AC power distribution section 3 is also coupled with that of the components in the electronic chamber 102. Compared with the conventional technology where the first cabinet and the second cabinet dissipate heat separately (each modular assembly dissipates heat independently), the heat dissipation costs are reduced. Moreover, the components in the electronic chamber 102, the DC power distribution section 2, and the AC power distribution section 3 are all arranged in the closed first circulating air duct, ensuring their protection requirements and thereby improving the overall protection reliability of the inverter.

Furthermore, in the above structure, the air within the first circulating air duct may dissipate heat from the power module, and the air within the heat dissipation chamber 101 may also dissipate heat from the power module, achieving dual heat dissipation for the power module and effectively improving its heat dissipation efficiency and effect.

The first connecting channel 5 is located at the end of the DC power distribution chamber 201 away from the electronic chamber 102 and at the end of the AC power distribution chamber 202 away from the electronic chamber 102. In other words, the first connecting channel 5 is located on one side of the DC power distribution chamber 201 near the bottom and also on one side of the AC power distribution chamber 202 near the bottom. That is, the first connecting channel 5 is located at the bottom of the second cabinet 200. The air duct in the DC power distribution chamber 201 extends from the top to the bottom of the DC power distribution chamber 201, and the air duct in the AC power distribution chamber 202 extends from the top to the bottom of the AC power distribution chamber 202.

In a case that the third air outlet 205 of the filter reactor chamber 203 is located at the top of the filter reactor chamber 203 near the AC power distribution chamber 202, to facilitate the communication between the AC power distribution chamber 202 and the electronic chamber 102, the AC power distribution chamber 202 and the electronic chamber 102 may be in communication through a second connecting channel 6. In this case, the DC power distribution chamber 201, the first connecting channel 5, the AC power distribution chamber 202, the second connecting channel 6, and the electronic chamber 102 are sequentially connected end to end to form the first circulating air duct.

The second connecting channel 6 is located at the end of the AC power distribution chamber 202 near the electronic chamber 102, that is, at the top of the AC power distribution chamber 202. In other words, the second connecting channel 6 is located at the top of the second cabinet 200 near the AC power distribution chamber 202.

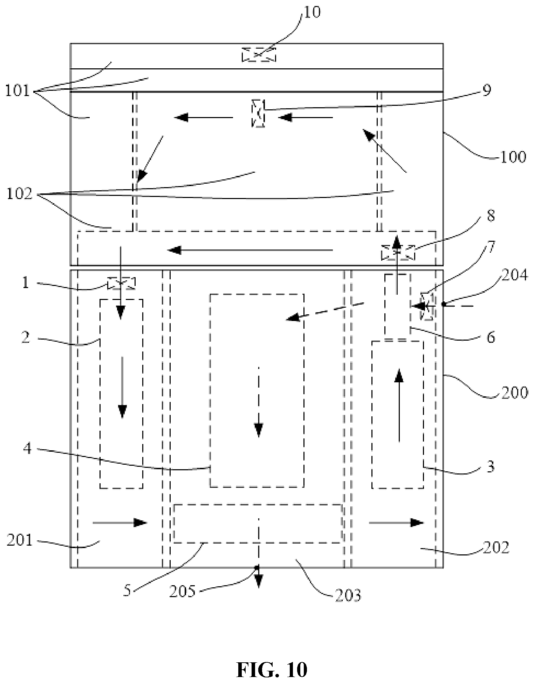

As shown in FIG. 1, the third air inlet 204, the first connecting channel 5, the reactor 4, the second connecting channel 6, and the third air outlet 205 are arranged in sequence. Alternatively, as shown in FIG. 10, the third air inlet 204, the second connecting channel 6, the reactor 4, the first connecting channel 5, and the third air outlet 205 are arranged in sequence.

In actual situations, the DC power distribution chamber 201 and the AC power distribution chamber 202 may be in communication with the electronic chamber 102 to form the first circulating air duct in any other manner, not limited to the first connecting channel 5 and second connecting channel 6 mentioned above.

To ensure the air circulation within the first circulating air duct, a fan is provided inside the first circulating air duct. For example, the first circulating air duct is provided therein with a third fan 1, a fourth fan 8, and a fifth fan 9. The third fan 1 is located at an end of the DC power distribution chamber 201 near the electronic chamber 102. The fourth fan 8 is located at an end of the electronic chamber 102 near the AC power distribution chamber 202. The fifth fan 9 is located at an end of the electronic chamber 102 away from the DC power distribution chamber 201 and away from the AC power distribution chamber 202.

In actual situations, the positions and number of the third fan 1, the fourth fan 8, and the fifth fan 9 may be adjusted based on actual needs. An additional fan may be provided, or at least one of the third fan 1, the fourth fan 8, and the fifth fan 9 may be omitted, depending on practical requirements.

If there are many components in the above-mentioned electronic chamber 102, to improve heat dissipation effect and efficiency, the inner space of the electronic chamber 102 may be divided into two parallel air ducts. In this way, the air flowing out of the AC power distribution chamber 202 enters the electronic chamber 102 and splits into two parts. After passing through the electronic chamber 102, the two parts of airflow converge and flow into the DC power distribution chamber 201. This arrangement allows the air to flow through components in each electronic chamber 102 as much as possible, thereby improving heat dissipation effect.

In actual situations, the air entering the electronic chamber 102 may be a single stream or may be split into at least three streams, which is not limited to the above-mentioned structure.

Since the DC power distribution chamber 201, the AC power distribution chamber 202, and the electronic chamber 102 form the first circulating air duct, the air inside the first circulating air duct will be gradually heated up. To ensure the normal operation of the components in the first circulating air duct, the air inside the first circulating air duct needs to be cooled. To this end, a first heat exchanger (not shown) is provided inside the second cabinet 200. This first heat exchanger is used to facilitate heat exchange between the air in the first circulating air duct and the air flowing through the filter reactor chamber 203, thereby cooling the air in the first circulating air duct. In this way, the heat dissipation of the components in the first circulating air duct is also coupled with the heat dissipation of the components in the filter reactor chamber 203, further reducing heat dissipation costs.

The first heat exchanger in this embodiment may be an air-to-air heat exchanger. This first heat exchanger may have a first heat exchange channel and a second heat exchange channel capable of heat exchange.

The first heat exchanger may be arranged at the location of the first connecting channel 5 and/or the location of the second connecting channel 6.

Taking the first heat exchanger arranged at the location of the first connecting channel 5 as an example, as shown in FIG. 1, the first heat exchange channel forms the first connecting channel 5, so that the first heat exchange channel is connected in series in the first circulating air duct, and the second heat exchange channel is connected in series in the air duct of the filter reactor chamber 203. In this way, when air flows through the second heat exchange channel of the first heat exchanger, it can cool the gas inside the first heat exchange channel, i.e., the gas inside the first circulating air duct, thereby improving the heat dissipation effect of the components in the first circulating air duct. To improve heat dissipation efficiency, air may flow through the second heat exchange channel of the first heat exchanger before passing through the reactor 4. In this case, the second heat exchange channel of the first heat exchanger is located between the third air inlet 204 of the filter reactor chamber 203 and the reactor 4. It is understood that the first heat exchanger is located between the third air inlet 204 of the filter reactor chamber 203 and the reactor 4. Since the first connecting channel 5 is at the bottom of the second cabinet 200, the third air inlet 204 is also at the bottom of the second cabinet 200.

It should be noted that the first heat exchange channel in the above structure can be understood as one structural implementation of the first connecting channel 5.

Taking the first heat exchanger arranged at the location of the second connecting channel 6 as an example, as shown in FIG. 10, the first heat exchange channel forms the second connecting channel 6, so that the first heat exchange channel is connected in series in the first circulating air duct, and the second heat exchange channel is connected in series in the air duct of the filter reactor chamber 203. In this way, when air flows through the second heat exchange channel of the first heat exchanger, it can cool the gas inside the first heat exchange channel, i.e., the gas inside the first circulating air duct, thereby improving the heat dissipation effect of the components in the first circulating air duct. To improve heat dissipation efficiency, air may flow through the second heat exchange channel of the first heat exchanger before passing through the reactor 4. In this case, the second heat exchange channel of the first heat exchanger is located between the third air inlet 204 of the filter reactor chamber 203 and the reactor 4. It is understood that the first heat exchanger is arranged between the third air inlet 204 of the filter reactor chamber 203 and the reactor 4. Since the second connecting channel 6 is at the top of the second cabinet 200 near the AC power distribution chamber 202, the third air inlet 204 is also at the top of the second cabinet 200 near the AC power distribution chamber 202.

It should be noted that the first heat exchange channel in the above structure may be understood as one structural implementation of the second connecting channel 6.

In a case that the first heat exchanger is provided between the third air inlet 204 of the filter reactor chamber 203 and the reactor 4, the second fan 7 may be provided at the third air outlet 205 of the filter reactor chamber 203. Alternatively, the second fan 7 may be provided at the third air inlet 204 of the filter reactor chamber 203. The first heat exchanger may be of any other type, which is not limited to the above structure. In some other examples, the first heat exchanger may have only one heat exchange channel (which may be referred to as the first heat exchange channel). The outer surface of the first heat exchanger is capable of heat exchange with the first heat exchange channel. The first heat exchanger is placed inside the filter reactor chamber 203, and its first heat exchange channel is connected in series in the first circulating air duct. The gas inside the filter reactor chamber 203 directly flows over the outer surface of the first heat exchanger to cool the gas inside the first heat exchange channel, thereby cooling the gas inside the first circulating air duct. In a case that the first heat exchanger is provided at the first connecting channel 5, the first heat exchange channel of the first heat exchanger may be understood as one structural implementation of the first connecting channel 5. In a case that the first heat exchanger is provided at the second connecting channel 6, the first heat exchange channel of the first heat exchanger may be understood as one structural implementation of the second connecting channel 6.

In actual situations, it is also possible to provide two or more first heat exchangers, with at least one being provided at the first connecting channel 5 and at least another one being provided at the second connecting channel 6. For example, in the structures shown in FIGS. 1 and 10, two first heat exchangers may be provided, and located at the first connecting channel 5 and the second connecting channel 6, respectively.

### Second Embodiment

The main difference between the heat dissipation structure of the inverter provided in the second embodiment and that in the first embodiment lies in the different circulation paths of the first circulating air duct, especially the different air duct structures within the DC power distribution chamber 201 and the AC power distribution chamber 202.

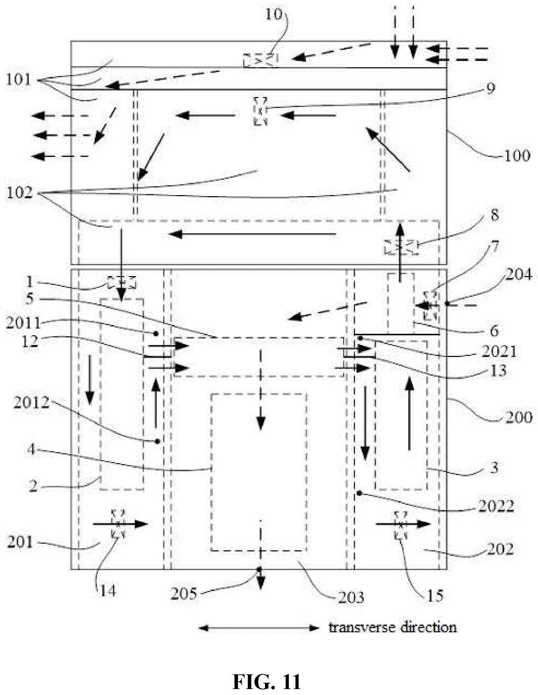

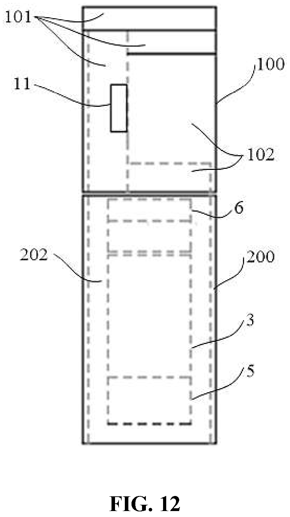

As shown in FIGS. 11 to 14, in this second embodiment, the DC power distribution chamber 201 includes a first DC sub-air duct 2011 and a second DC sub-air duct 2012 which are connected in parallel, and the AC power distribution chamber 202 includes a first AC sub-air duct 2021 and a second AC sub-air duct 2022 which are connected in parallel. The first DC sub-air duct 2011 is in communication with the first AC sub-air duct 2021, and the second DC sub-air duct 2012 is in communication with the second AC sub-air duct 2022. In this way, the first circulating air duct has two parallel branches in the second cabinet 200, one of which includes the first DC sub-air duct 2011 and the first AC sub-air duct 2021, and the other of which includes the second DC sub-air duct 2012 and the second AC sub-air duct 2022.

In the second embodiment, since the first circulating air duct has two parallel branches in the second cabinet 200, air can flow through each of the components in the DC power distribution chamber 201 and each of the components in the AC power distribution chamber 202 as much as possible, effectively improving the heat dissipation effect.

In the second embodiment, the connection position of the first DC sub-air duct 2011 and the first AC sub-air duct 2021, as well as the connection position of the second DC sub-air duct 2012 and the second AC sub-air duct 2022, may be determined based on actual conditions.

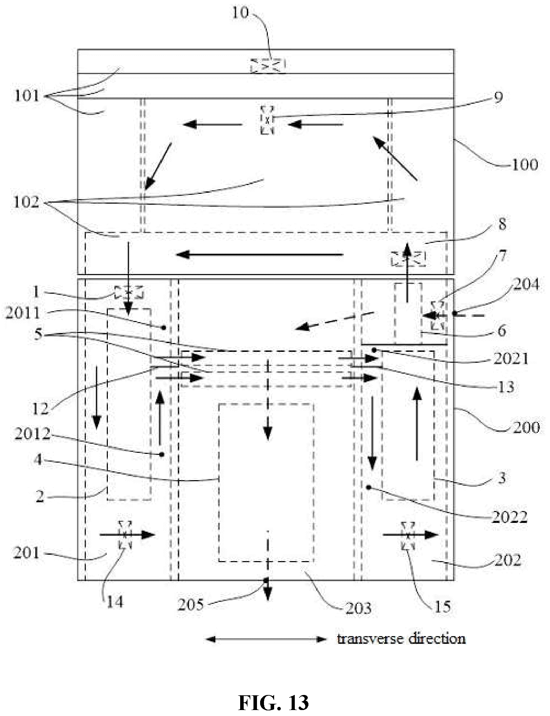

As shown in FIGS. 11 and 13, in some embodiments, between the top and bottom ends of the DC power distribution chamber 201 and also between the top and bottom ends of the AC power distribution chamber 202, the first DC sub-air duct 2011 is communicated with the first AC sub-air duct 2021, and the second DC sub-air duct 2012 is communicated with the second AC sub-air duct 2022. The second DC sub-air duct 2012 passes through the bottom end of the DC power distribution chamber 201, and the second AC sub-air duct 2022 passes through the bottom end of the AC power distribution chamber 202.

As shown in FIG. 11, the first DC sub-air duct 2011 and the first AC sub-air duct 2021, as well as the second DC sub-air duct 2012 and the second AC sub-air duct 2022, may be in communication through a common first connecting channel 5. As shown in FIG. 13, the first DC sub-air duct 2011 and the first AC sub-air duct 2021, as well as the second DC sub-air duct 2012 and the second AC sub-air duct 2022, may be in communication through different first connecting channels 5.

As shown in FIGS. 11 and 13, the top end of the AC power distribution chamber 202 is in communication with the electronic chamber 102 through a second connecting channel 6. The air inlet of the filter reactor chamber 203, the second connecting channel 6, the first connecting channel 5, and the reactor 4 are sequentially distributed along the direction of airflow within the filter reactor chamber 203. At least one first heat exchanger is arranged at each first connecting channel 5, and/or at least one first heat exchanger is arranged at the second connecting channel 6.

It should be noted that the sentence "at least one first heat exchanger is arranged at each first connecting channel 5, and/or at least one first heat exchanger is arranged at the second connecting channel 6" may be understood with reference to the first embodiment, which will not repeated here.

In the above embodiments, air sequentially flows through the second connecting channel 6, the first connecting channel 5, and the reactor 4. In this way, air flowing through the second connecting channel 6 and the first connecting channel 5 firstly may better cool the air within the first circulating air duct, thereby improving the heat dissipation efficiency of the components within the first circulating air duct. In a case that the first heat exchanger is arranged at the first connecting channel 5 and the second connecting channel 6, the heat exchange area is increased, and the heat exchange efficiency is improved.

In the above structure, part of the air entering the DC power distribution chamber flows through the first DC sub-air duct 2011 of the DC power distribution chamber 201 and enters the first AC sub-air duct 2021 through the first connecting channel 5. The other part of the air entering the DC power distribution chamber flows through the second DC sub-air duct 2012 of the DC power distribution chamber 201 and enters the second AC sub-air duct 2022 through the first connecting channel 5. The air flowing out of the first AC sub-air duct 2021 and the air flowing out of the second AC sub-air duct 2022 converge in the second connecting channel 6 and then flow into the electronic chamber 102.

As can be seen from the above airflow path within the first circulating air duct, it is possible to achieve the circulation flow of air within the first circulating air duct, and enable the air to flow through the bottom of the DC power distribution chamber 201 and the bottom of the AC power distribution chamber 202, thus improving the heat exchange effect and efficiency for the DC power distribution section 2 and the AC power distribution section 3.

To avoid a short circuit between the first DC sub-air duct 2011 and the second DC sub-air duct 2012 at the first connecting channel 5, the DC power distribution chamber 201 may be provided therein with a first partition plate 12. The first partition plate 12 separates the end of the first DC sub-air duct 2011 connected to the first connecting channel 5 from the end of the second DC sub-air duct 2012 connected to the first connecting channel 5. It can be understood that the first partition plate 12 also separates the port of the first connecting channel 5 connected to the first DC sub-air duct 2011 from the port of the first connecting channel 5 connected to the second DC sub-air duct 2012.

Correspondingly, to avoid a short circuit between the first AC sub-air duct 2021 and the second AC sub-air duct 2022 at the first connecting channel 5, the AC power distribution chamber 202 may be provided therein with a second partition plate 13. The second partition plate 13 separates the end of the first AC sub-air duct 2021 connected to the first connecting channel 5 from the end of the second AC sub-air duct 2022 connected to the first connecting channel 5. It can be understood that the first partition plate 12 also separates the port of the first connecting channel 5 connected to the first AC sub-air duct 2021 from the port of the first connecting channel 5 connected to the second AC sub-air duct 2022.

For example, as shown in FIG. 11, there is a single first connecting channel 5. The first partition plate 12 divides the inlet of the first connecting channel 5 into two non-communicated upper and lower parts, and the second partition plate 13 divides the outlet of the first connecting channel 5 into two non-communicated upper and lower parts. As shown in FIG. 13, there are two first connecting channels 5. In this case, the first partition plate 12 separates the inlets of the two first connecting channels 5, and the second partition plate 13 separates the outlets of the two first connecting channels 5. One of the first connecting channels 5 communicates the first DC sub-air duct 2011 and the first AC sub-air duct 2021, and the other of the first connecting channels 5 communicates the second DC sub-air duct 2021 and the second AC sub-air duct 2022.

In the above embodiments, more first connecting channels 5 may be provided as required. For example, there are provided three first connecting channels 5, two of which are isolated from the other one at their inlets by the first partition plate 12 and at their outlets by the second partition plate 13. For example, four or more first connecting channels 5 may be provided, and the roles and functions of the first partition plate 12 and the second partition plate 13 may be adjusted adaptively, which is not described in detail here.

In this embodiment, the first DC sub-air duct 2011 and the second DC sub-air duct 2012, as well as the first AC sub-air duct 2021 and the second AC sub-air duct 2022, may be formed in other manners, which is not limited to the use of the first partition plate 12 and the second partition plate 13.

In addition to the configurations shown in FIGS. 11 and 13, where the first DC sub-air duct 2011 and the second DC sub-air duct 2012 are arranged vertically one on top of another at the first partition plate 12, it is also possible to arrange the first DC sub-air duct 2011 and the second DC sub-air duct 2012 sequentially in the longitudinal direction at the first partition plate 12. The longitudinal direction is perpendicular to both the vertical and transverse directions. It should be understood that the transverse direction refers to a direction in which the DC power distribution chamber 201, the filter reactor chamber 203, and the AC power distribution chamber 202 are sequentially distributed.

Correspondingly, at the second partition plate 13, the first AC sub-air duct 2021 and the second AC sub-air duct 2022 may be sequentially arranged in the longitudinal direction.

It is also possible to arrange the first DC sub-air duct 2011 and the second DC sub-air duct 2012 sequentially in any other direction at the first partition plate 12, and arrange the first AC sub-air duct 2021 and the second AC sub-air duct 2022 sequentially in any other direction at the second partition plate 13, which is not limited in this second embodiment.

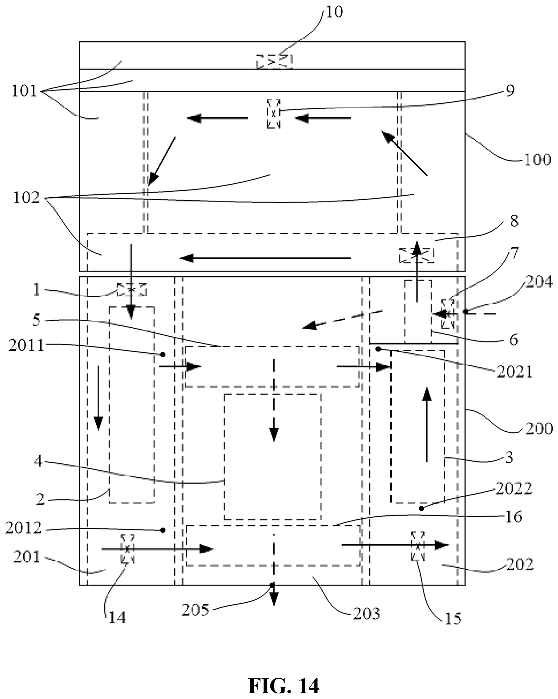

In the second embodiment, the second DC sub-air duct 2012 and the second AC sub-air duct 2022 may be connected at any other location. As shown in FIG. 14, in some other embodiments, between the top and bottom of the DC power distribution chamber 201 and between the top and bottom of the AC power distribution chamber 202, the first DC sub-air duct 2011 and the first AC sub-air duct 2021 may be communicated with each other; and, at the bottom of the DC power distribution chamber 201 and at the bottom of the AC power distribution chamber 202, the second DC sub-air duct 2012 and the second AC sub-air duct 2022 may be communicated with each other.

In the above embodiments, the first DC sub-air duct 2011 and the first AC sub-air duct 2021 are in communication through the first connecting channel 5, and the second DC sub-air duct 2012 and the second AC sub-air duct 2022 are in communication through the third connecting channel 16. The AC power distribution chamber 202 is in communication with the electronic chamber 102 through the second connecting channel 6. The air inlet (the third air inlet 204) of the filter reactor chamber 203, the second connecting channel 6, the first connecting channel 5, the reactor 4, and the third connecting channel 16 are sequentially arranged along the direction of airflow within the filter reactor chamber 203. At least one first heat exchanger is provided at the first connecting channel 5, and/or at least one first heat exchanger is provided at the third connecting channel 16, and/or at least one first heat exchanger is provided at the second connecting channel 6.

The third connecting channel 16 may be located at the bottom of the reactor 4 and also at the bottom of the second cabinet 200.

The sentence "at least one first heat exchanger is provided at the first connecting channel 5, and at least one first heat exchanger is provided at the second connecting channel 6" may be understood with reference to the first embodiment, which will not be repeated here.

In a case that at least one first heat exchanger is provided at the third connecting channel 16, the first heat exchange channel of the first heat exchanger forms the third connecting channel to be connected in series in the first circulating air duct, and the second heat exchange channel of the first heat exchanger is connected in series in the air duct of the filter reactor chamber 203. This further increases the heat exchange area and improves the heat exchange efficiency.

In the second embodiment, to facilitate passage of air through the second DC sub-air duct 2012 and the second AC sub-air duct 2022, a sixth fan 14 is provided at the bottom of the DC power distribution chamber 201, and is arranged in the second DC sub-air duct 2012, and a seventh fan 15 is also provided at the bottom of the AC power distribution chamber 202, and is arranged in the second AC sub-air duct 2022.

The inlet and outlet positions of the first connecting channel 5 may be interchanged. As a result, the outlet of the first connecting channel 5 is in communication with the DC power distribution chamber 201, and the inlet of the first connecting channel 5 is in communication with the AC power distribution chamber 202. In a case that the first partition plate 12 and the second partition plate 13 are provided, the roles and functions of the first partition plate 12 and the second partition plate 13 may be adjusted adaptively, which will not be repeated here. In a case that the third connecting channel 16 is provided, the inlet and outlet of the third connecting channel 16 follow the same arrangement as those of the first connecting channel 5.

For other constructions of the heat dissipation structure of the inverter and the heat exchange in its chambers in this second embodiment, reference may be made to the first embodiment, which will not be repeated here.

### Third Embodiment

The main difference between the heat dissipation structure of the inverter provided in the third embodiment and that in the first embodiment lies in the different circulation paths of the first circulating air duct, especially the different air duct structures within the DC power distribution chamber 201 and the AC power distribution chamber 202. Moreover, a second circulating air duct is additionally provided in the third embodiment.

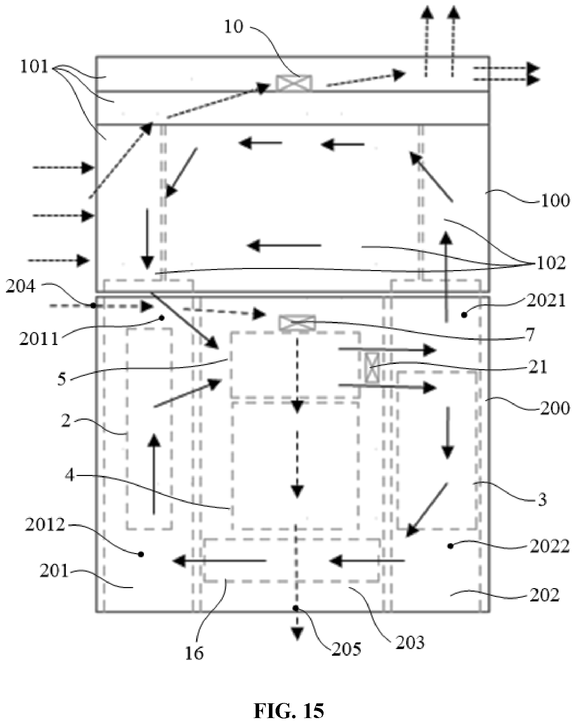

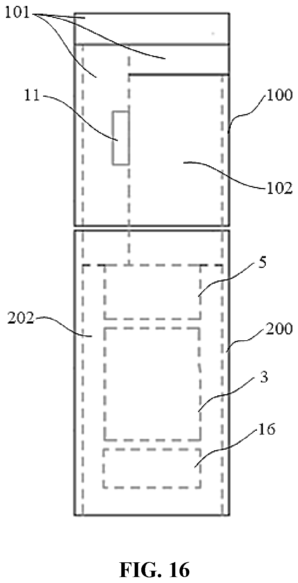

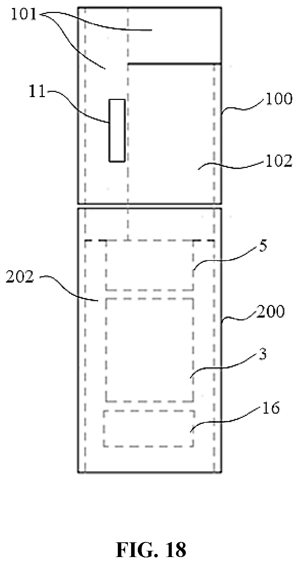

In the third embodiment, as shown in FIGS. 15 to 20, the DC power distribution chamber 201 includes a first DC sub-air duct 2011 and a second DC sub-air duct 2012, with the first DC sub-air duct 2011 being closer to the electronic chamber 102 than the second DC sub-air duct 2012; and the AC power distribution chamber 202 includes a first AC sub-air duct 2021 and a second AC sub-air duct 2022, with the first AC sub-air duct 2021 being closer to the electronic chamber 102 than the second AC sub-air duct 2022.

In the above structure, the first DC sub-air duct 2011 forms part of the first circulating air duct, and the first AC sub-air duct 2021 forms part of the first circulating air duct. The second DC sub-air duct 2012 and the second AC sub-air duct 2022 are in communication to form the second circulating air duct. In this case, at least one first heat exchanger is used to exchange heat between the air in the second circulating air duct and the air flowing through the filter reactor chamber 203.

In the third embodiment, the circulation path of the first circulating air duct is shortened, and correspondingly, the circulation path of the second circulating air duct is also shortened, effectively improving the heat dissipation effect. Moreover, at least one first heat exchanger is used to exchange heat between the air in the second circulating air duct and the air flowing through the filter reactor chamber 203, increasing the heat exchange area and further improving the heat dissipation efficiency and effect.

In the third embodiment, the first circulating air duct and the second circulating air duct are arranged in parallel. To simplify the structure and reduce the temperature difference between the first circulating air duct and the second circulating air duct, the first circulating air duct and the second circulating air duct may share a section of the air duct, and at least one first heat exchanger is arranged at the section of the air duct shared by the first circulating air duct and the second circulating air duct. In this case, the first circulating air duct and the second circulating air duct share at least one first heat exchanger.

To facilitate the formation of the first circulating air duct and the second circulating air duct, the first DC sub-air duct 2011 and the first AC sub-air duct 2021, as well as the second DC sub-air duct 2012 and the second AC sub-air duct 2022, are in communication through the first connecting channel 5, and the second DC sub-air duct 2012 and the second AC sub-air duct 2022 are additionally in communication through the third connecting channel 16. The electronic chamber 102, the first DC sub-air duct 2011, the first connecting channel 5, and the first AC sub-air duct 2021 are sequentially connected end to end to form the first circulating air duct. The second DC sub-air duct 2012, the first connecting channel 5, the second AC sub-air duct 2022, and the third connecting channel 16 are sequentially connected end to end to form the second circulating air duct. In this case, the first circulating air duct and the second circulating air duct share the first connecting channel 5.

In the third embodiment, to facilitate air flow within the first circulating air duct and the second circulating air duct, as shown in FIGS. 15, 17, 19, and 20, an eighth fan 21 is provided within the second cabinet 200. The eighth fan 21 may be provided at the outlet end or the inlet end of the first connecting channel 5. This allows the first circulating air duct and the second circulating air duct to share the same eighth fan 21, which helps reduce the number of fans and lower costs of the fans, and also reduce the occupation of internal space of the second cabinet 200.

To facilitate air circulation within the first circulating air duct, a fan may be provided inside the first circulating air duct. For specific positions and number of the fans, reference may be made to the first embodiment, which will not be repeated here.

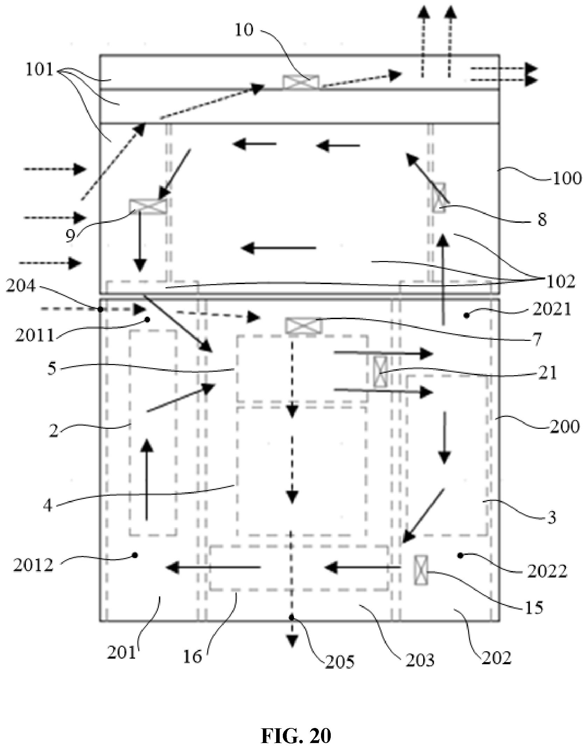

As shown in FIG. 20, to facilitate air flow within the second circulating air duct, a seventh fan 15 may be provided inside the second circulating air duct. The seventh fan 15 is located in the second DC sub-air duct 2012 and/or the second AC sub-air duct 2022. As an example, the seventh fan 15 is arranged at the bottom of the second DC sub-air duct 2012 and/or the second AC sub-air duct 2022, that is, the seventh fan 15 is arranged at the bottom of the second cabinet 200.

In practical applications, the number and positions of fans within the first and second circulating air ducts may be adjusted based on actual conditions, which is not limited in the third embodiment.

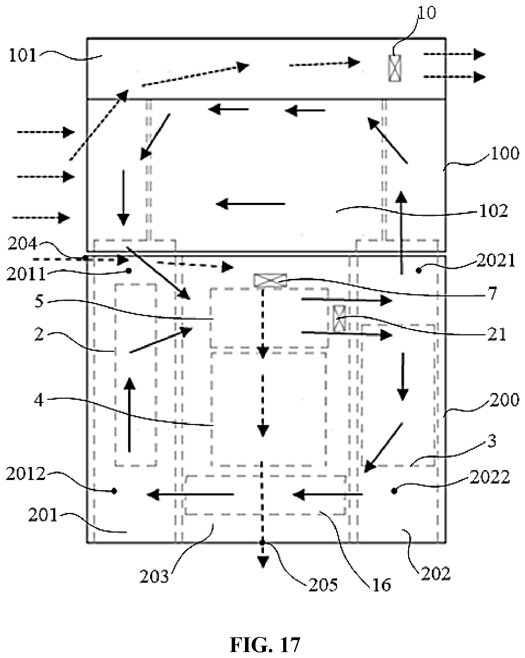

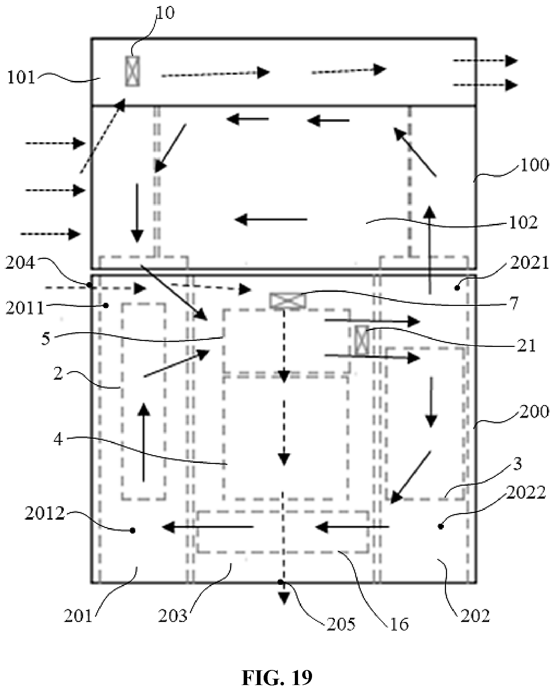

In the third embodiment, a first fan 10 is provided at the top of the heat dissipation chamber 101. As shown in FIG. 15, the first fan 10 is arranged in the middle (between the front and rear sides) of the top of the first cabinet 100. As shown in FIG. 17, the first fan 10 is arranged at the top of the first cabinet 100 near the rear side. As shown in FIG. 19, the first fan 10 is arranged at the top of the first cabinet 100 near the front side.

For other constructions of the heat dissipation structure of the inverter in the third embodiment, as well as heat exchange within its chambers, reference may be made to the first embodiment and the second embodiment, which will not be repeated here.

### Fourth Embodiment

The heat dissipation structure of the inverter provided in the fourth embodiment differs from those in the first embodiment, the second embodiment and the third embodiment primarily in chamber(s) forming the first circulating air duct.

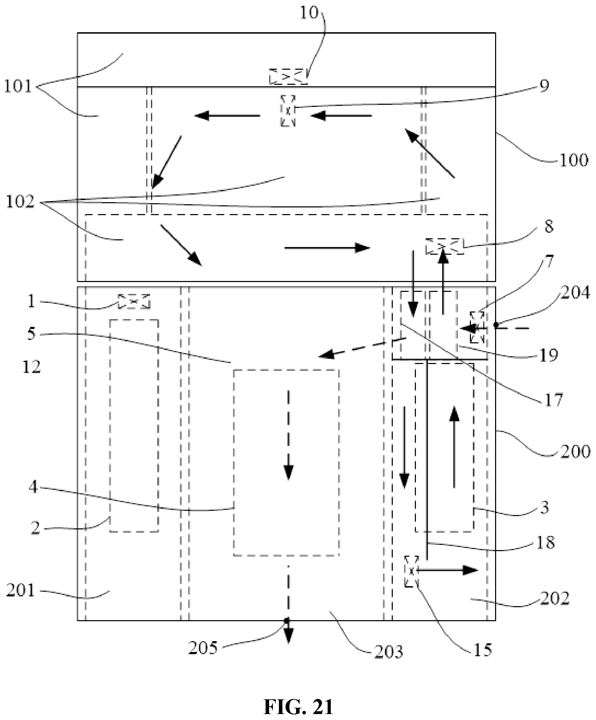

In the fourth embodiment, as shown in FIG. 21, the AC power distribution chamber 202 and the electronic chamber 102 are in communication with each other to form the first circulating air duct, and the DC power distribution chamber 201 is not in communication with the electronic chamber 102. The air inside the DC power distribution chamber 201 is disturbed to achieve heat dissipation. In practical applications, the DC power distribution chamber 201 may be configured as a closed chamber.

To facilitate the communication between the AC power distribution chamber 202 and the electronic chamber 102 to form the first circulating air duct, the second cabinet 200 is provided therein with a fourth connecting channel 19 (i.e., the second connecting channel 6 mentioned earlier) and a fifth connecting channel 17.

The outlet of the AC power distribution chamber 202 is in communication with the inlet of the electronic chamber 102 through the fourth connecting channel 19, and the outlet of the electronic chamber 102 is in communication with the inlet of the AC power distribution chamber 202 through the fifth connecting channel 17.

Both the fourth connecting channel 19 and the fifth connecting channel 17 are arranged at the top of the AC power distribution chamber 202, so the inlet and outlet of the AC power distribution chamber 202 are also arranged at the top of the AC power distribution chamber 202. To ensure that air flows through the bottom of the AC power distribution chamber 202 to improve heat dissipation effect, the AC power distribution chamber 202 is provided therein with a third partition plate 18 and a seventh fan 15. The third partition plate 18 separates the inlet from the outlet of the AC power distribution chamber 202, and the seventh fan 15 is located at the bottom of the AC power distribution chamber 202.

To enhance separation effect, the third partition plate 18 extends from the top to the bottom of the AC power distribution chamber 202. Airflow on one side of the third partition 18 flows to the other side via the seventh fan 15.

In practical applications, the positions of the fourth connecting channel 19 and the fifth connecting channel 17 may be interchanged. Specifically, the outlet of the AC power distribution chamber 202 is in communication with the inlet of the electronic chamber 102 through the fifth connecting channel 17, and the outlet of the electronic chamber 102 is in communication with the inlet of the AC power distribution chamber 202 through the fourth connecting channel 19.

In the above embodiments, to achieve heat dissipation from the reactor 4, the third air inlet 204 of the filter reactor chamber 203 is located on one side of the second cabinet 200 near the top. The third air inlet 204, the second connecting channel 6, the fourth connecting channel 19, and the reactor 4 are sequentially arranged along the airflow direction, and the first heat exchanger is provided at the fourth connecting channel 19 and/or the fifth connecting channel 17. Thus, when entering the filter reactor chamber 203 through the third air inlet 204, air flows sequentially through the fourth connecting channel 19, the fifth connecting channel 17, and the reactor 4, then exits through the third air outlet 205 of the filter reactor chamber 203.

In the above structure, in a case that the first heat exchanger is provided at the fourth connecting channel 19, the first heat exchange channel of the first heat exchanger serves as the fourth connecting channel 19 to be connected in series within the first circulating air duct, and the second heat exchange channel of the first heat exchanger is connected in series within the air duct of the AC power distribution chamber 202. Additionally/alternatively, in a case that the first heat exchanger is provided at the fifth connecting channel 17, the first heat exchange channel of the first heat exchanger serves as the fifth connecting channel 17 to be connected in series within the first circulating air duct, and the second heat exchange channel of the first heat exchanger is connected in series within the air duct of the AC power distribution chamber 202. In this way, air flowing through the second heat exchange channel of the first heat exchanger exchanges heat with the air inside the first heat exchange channel, thereby achieving heat dissipation from the components within the first circulating air duct.

To improve the heat dissipation efficiency of the components within the first circulating air duct, the first heat exchanger may be provided at the fourth connecting channel 19 and, optionally, the fifth connecting channel 17.

The number of first heat exchanger may be one or more, depending on actual conditions, which is not limited to the fourth embodiment.

In the above embodiments, the inlet and outlet of the electronic chamber 102 are both located at the bottom of the electronic chamber 102. To ensure the heat dissipation efficiency and effect of the electronic chamber 102, the electronic chamber 102 is provided with a fifth partition plate that separates its inlet and outlet. The inlet and outlet of the electronic chamber 102 may be isolated in any other manner to ensure that air flows through the components to be cooled within the electronic chamber 102.

To facilitate airflow through the top of the electronic chamber 102, a fifth fan 9 is provided at the top of the electronic chamber 102. Under the action of the fifth fan, air inside the electronic chamber 102 flows from its inlet to its outlet.

In the fourth embodiment, heat dissipation is achieved through air disturbance within the DC power distribution chamber 201. To facilitate air disturbance inside the DC power distribution chamber 201, a third fan 1 is provided within the DC power distribution chamber 201. The position of the third fan 1 may be determined according to actual conditions, which is not limited in the third embodiment.

In a case that air disturbance inside the DC power distribution chamber 201 fails to meet heat dissipation requirements, the second cabinet 200 may be provided with an additional second heat exchanger (not shown). This second heat exchanger has first and second channels capable of heat exchange. The first channel of the second heat exchanger is in communication with the DC power distribution chamber 201, and the second channel allows air to flow through.

The air entering the second channel of the second heat exchanger may be air outside the second channel, e.g., air outside the entire second cabinet. In this case, the second channel of the second heat exchanger is in communication with the outside of the second cabinet 200.

In the above structure, air flowing through the second channel exchanges heat with the air inside the first channel, thereby cooling the components within the DC power distribution chamber 201, improving the heat dissipation efficiency and effect of components within the DC power distribution chamber 201, and meeting its heat dissipation requirements.

The second heat exchanger may be provided on the door or at any other position of the second cabinet 200, which is not limited in the third embodiment.

The number of second heat exchanger may be one or more, depending on the heat dissipation requirements of the DC power distribution chamber 201, which is not limited in the third embodiment.

In the fourth embodiment, the DC power distribution chamber 201 and the electronic chamber 102 may be configured to be in communication to form the first circulating air duct, while the AC power distribution chamber 202 is not in communication with the electronic chamber 102. For example, the AC power distribution chamber 202 is a closed chamber, in which case air within the AC power distribution chamber 202 is disturbed to achieve the heat dissipation. In this case, the design of the first circulating air duct and other structures may be adjusted adaptively, which will not be repeated here.

For other constructions of the heat dissipation structure of the inverter in the fourth embodiment, as well as heat exchange within its chambers, reference may be made to the first embodiment, the second embodiment, and the third embodiment, which will not be repeated here.

### Fifth Embodiment

The heat dissipation structure of the inverter provided in the fifth embodiment differs from those in the first embodiment, the second embodiment, the third embodiment, and the fourth embodiment primarily in the internal structure of the heat dissipation chamber.

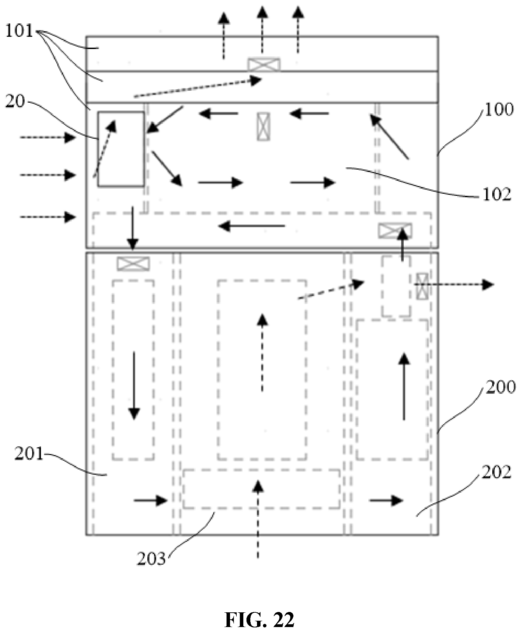

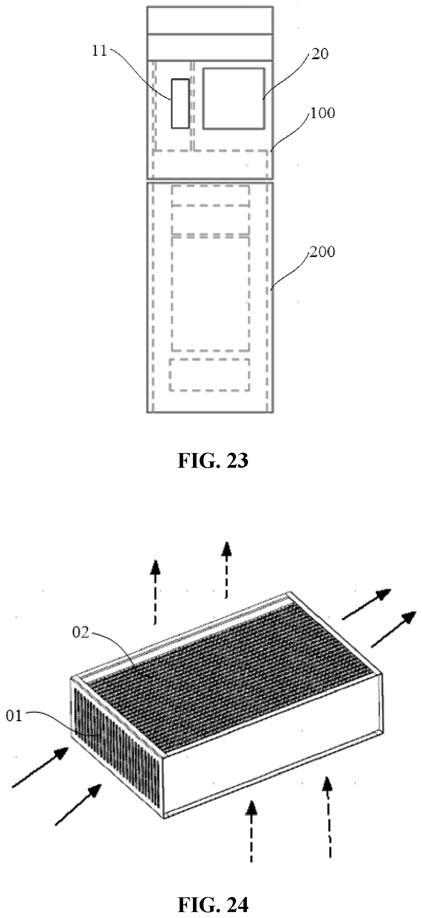

In a case that the solutions provided in the first embodiment, the second embodiment, the third embodiment, and the fourth embodiment fail to meet the heat dissipation requirements of the electronic chamber 102, a third heat exchanger 20 may be additionally provided in the heat dissipation chamber 101 as shown in FIGS. 22 and 23, and the third heat exchanger 20 may be an air-to-air heat exchanger.

The third heat exchanger 20 has first and second channels capable of heat exchange. The first channel is in communication with the heat dissipation chamber 101, and the second channel is in communication with the electronic chamber 102. Thus, cold air flowing into the heat dissipation chamber 101 flows through the first channel, and during this process, performs heat exchange with the second channel, cooling the air inside the second channel and thereby cooling the components within the electronic chamber 102.

It should be noted that, when the third heat exchanger 20 meets the heat dissipation requirements of the electronic chamber 102, the first heat exchanger mentioned in the first embodiment, the second embodiment, the third embodiment, and the fourth embodiment may be omitted, or its position and number may be adjusted.

In practical applications, the third heat exchanger 20 may be provided inside the electronic chamber 102, and be not limited to the heat dissipation chamber 101.

For other configurations of the heat dissipation structure of the inverter in the fifth embodiment, as well as heat exchange within its chambers, reference may be made to the first embodiment, the second embodiment, the third embodiment, and the fourth embodiment, which will not be repeated here.

The air-to-air heat exchangers mentioned in the first embodiment, the second embodiment, the third embodiment, the fourth embodiment, and the fifth embodiment may also be referred to as air-to-air heat transfer devices. As shown in FIG. 24, the first heat exchange channel 01 and the second heat exchange channel 02 of the air-to-air heat exchanger may be perpendicular to each other. The first and second heat exchange channels may be of any other structure, which is not limited to the structure shown in FIG. 24.

Based on the heat dissipation structure of the inverter provided in the above embodiments, an inverter is further provided according to the embodiments of the present application. The inverter includes the heat dissipation structure of the inverter provided in the above embodiments.

In view of the technical effects bringing about by the heat dissipation structure of the inverter provided in the above embodiments, the inverter including the same also has corresponding technical effects, which are not repeated here.

The type of the aforementioned inverter may be selected based on actual circumstances. For example, the inverter may be a photovoltaic grid-connected inverter, which is not limited in the present application.

Based on the above description of the disclosed embodiments, those skilled in the art are capable of implementing or using the present application. It is apparent for those skilled in the art to make many modifications to these embodiments. The general principle defined herein may be applied to other embodiments without departing from the scope of the present application. Therefore, the present application should not be limited to the embodiments disclosed herein, but has the widest scope in accordance to the concept and the novel features disclosed herein.

## Claims

1. A heat dissipation structure for an inverter, **characterized in that** the heat dissipation structure comprises a first cabinet and a second cabinet, wherein
the first cabinet comprises a heat dissipation chamber and an electronic chamber, the electronic chamber is configured to house an inverter power module section, and the heat dissipation chamber is configured for air to flow through to cool a power module radiator, which is configured to dissipate heat from a power module of the inverter power module section; and
the second cabinet comprises a DC power distribution chamber and an AC power distribution chamber, the DC power distribution chamber is configured to house a DC power distribution section, and the AC power distribution chamber is configured to house an AC power distribution section, with at least one of the DC power distribution chamber and the AC power distribution chamber being in communication with the electronic chamber to form a first circulating air duct.

2. The heat dissipation structure for the inverter according to claim 1, wherein the second cabinet further comprises a filter reactor chamber, which is configured to house a reactor and for air to flow through to cool the reactor.

3. The heat dissipation structure for the inverter according to claim 2, wherein the second cabinet further comprises at least one first heat exchanger, which is configured to enable heat exchange between air in the first circulating air duct and air flowing through the filter reactor chamber.

4. The heat dissipation structure for the inverter according to claim 3, wherein at least one first heat exchanger is arranged between an air inlet of the filter reactor chamber and the reactor.

5. The heat dissipation structure for the inverter according to claim 3 or 4, wherein
the DC power distribution chamber comprises a first DC sub-air duct and a second DC sub-air duct, with the first DC sub-air duct being closer to the electronic chamber than the second DC sub-air duct;
the AC power distribution chamber comprises a first AC sub-air duct and a second AC sub-air duct, with the first AC sub-air duct being closer to the electronic chamber than the second AC sub-air duct; and
both the first DC sub-air duct and the first AC sub-air duct form respective portions of the first circulating air duct.

6. The heat dissipation structure for the inverter according to claim 5, wherein the second DC sub-air duct and the second AC sub-air duct are in communication to form a second circulating air duct; and
at least one first heat exchanger is configured to enable heat exchange between air in the second circulating air duct and the air flowing through the filter reactor chamber.

7. The heat dissipation structure for the inverter according to claim 6, wherein
the first circulating air duct and the second circulating air duct share a section of the air duct, and at least one first heat exchanger is located at the section shared by the first circulating air duct and the second circulating air duct.

8. The heat dissipation structure for the inverter according to claim 3 or 4, wherein the electronic chamber, the DC power distribution chamber, and the AC power distribution chamber are sequentially connected end to end to form the first circulating air duct.

9. The heat dissipation structure for the inverter according to claim 8, wherein an air duct in the DC power distribution chamber extends from a top of the DC power distribution chamber to a bottom of the DC power distribution chamber, and an air duct in the AC power distribution chamber extends from a top of the AC power distribution chamber to a bottom of the AC power distribution chamber.

10. The heat dissipation structure for the inverter according to claim 9, wherein the bottom of the DC power distribution chamber and the bottom of the AC power distribution chamber are in communication through a first connecting channel, and the top of the DC power distribution chamber or the top of the AC power distribution chamber is in communication with the electronic chamber through a second connecting channel; and
one of the first connecting channel and the second connecting channel is located between an air inlet of the filter reactor chamber and the reactor, and the other of the first connecting channel and the second connecting channel is located between an air outlet of the filter reactor chamber and the reactor.

11. The heat dissipation structure for the inverter according to claim 10, wherein at least one first heat exchanger is provided at the first connecting channel, and/or at least one first heat exchanger is provided at the second connecting channel.

12. The heat dissipation structure for the inverter according to claim 8, wherein the DC power distribution chamber comprises a first DC sub-air duct and a second DC sub-air duct which are connected in parallel, and the AC power distribution chamber comprises a first AC sub-air duct and a second AC sub-air duct which are connected in parallel; and
the first DC sub-air duct is in communication with the first AC sub-air duct, and the second DC sub-air duct is in communication with the second AC sub-air duct.

13. The heat dissipation structure for the inverter according to claim 12, wherein, between a top and a bottom of the DC power distribution chamber and between a top and a bottom of the AC power distribution chamber, the first DC sub-air duct is communicated with the first AC sub-air duct, and the second DC sub-air duct is communicated with the second AC sub-air duct; and
the second DC sub-air duct passes through the bottom of the DC power distribution chamber, and the second AC sub-air duct passes through the bottom of the AC power distribution chamber.

14. The heat dissipation structure for the inverter according to claim 13, wherein
the first DC sub-air duct and the first AC sub-air duct, as well as the second DC sub-air duct and the second AC sub-air duct, are in communication through a common first connecting channel; or the first DC sub-air duct and the first AC sub-air duct, as well as the second DC sub-air duct and the second AC sub-air duct, are in communication through different first connecting channels;
the top of the DC power distribution chamber or the top of the AC power distribution chamber is in communication with the electronic chamber through a second connecting channel; and
an air inlet of the filter reactor chamber, the second connecting channel, the first connecting channel, and the reactor are sequentially arranged along a direction of airflow within the filter reactor chamber.

15. The heat dissipation structure for the inverter according to claim 14, wherein at least one first heat exchanger is provided at each first connecting channel, and/or at least one first heat exchanger is provided at the second connecting channel.

16. The heat dissipation structure for the inverter according to claim 12, wherein
the first DC sub-air duct and the first AC sub-air duct are communicated between a top and a bottom of the DC power distribution chamber and between a top and a bottom of the AC power distribution chamber; and
the second DC sub-air duct and the second AC sub-air duct are communicated at the bottom of the DC power distribution chamber and at the bottom of the AC power distribution chamber.

17. The heat dissipation structure for the inverter according to claim 16, wherein the first DC sub-air duct and the first AC sub-air duct are in communication through a first connecting channel, and the second DC sub-air duct and the second AC sub-air duct are in communication through a third connecting channel;
the top of the DC power distribution chamber or the top of the AC power distribution chamber is in communication with the electronic chamber through a second connecting channel; and
an air inlet of the filter reactor chamber, the second connecting channel, the first connecting channel, the reactor, and the third connecting channel are sequentially arranged along a direction of airflow within the filter reactor chamber.

18. The heat dissipation structure for the inverter according to claim 17, wherein at least one first heat exchanger is provided at the first connecting channel, and/or
at least one first heat exchanger is provided at the third connecting channel, and/or
at least one first heat exchanger is provided at the second connecting channel.

19. The heat dissipation structure for the inverter according to claim 3 or 4, wherein
one of the DC power distribution chamber and the AC power distribution chamber is in communication with the electronic chamber to form the first circulating air duct, and the other of the DC power distribution chamber and the AC power distribution chamber is not in communication with the electronic chamber;
the second cabinet is provided with a fourth connecting channel and a fifth connecting channel; and
the one of the DC power distribution chamber and the AC power distribution chamber that is in communication with the electronic chamber, the fourth connecting channel, the electronic chamber, and the fifth connecting channel are sequentially connected end to end to form the first circulating air duct.

20. The heat dissipation structure for the inverter according to claim 19, wherein at least one first heat exchanger is provided at the fourth connecting channel; and/or
at least one first heat exchanger is provided at the fifth connecting channel.

21. The heat dissipation structure for the inverter according to claim 19, wherein the second cabinet is provided with a second heat exchanger, which has a first channel and a second channel for heat exchange, the other one of the DC power distribution chamber and the AC power distribution chamber, which is not in communication with the electronic chamber, is in communication with the first channel, and the second channel is configured for air to flow through.

22. The heat dissipation structure for the inverter according to claim 2, wherein
an air inlet and an air outlet of the heat dissipation chamber are located on different sides of the first cabinet, respectively, and an air inlet and an air outlet of the filter reactor chamber are located on different sides of the second cabinet, respectively;
the first cabinet and the second cabinet are referred to as a cabinet, the air outlet of the filter reactor chamber and the air inlet of the heat dissipation chamber are located on different sides of the cabinet, and the air outlet of the heat dissipation chamber and the air inlet of the filter reactor chamber are located on different sides of the cabinet; and/or,
the DC power distribution chamber and the AC power distribution chamber are distributed on opposite sides of the filter reactor chamber; and/or,
both the DC power distribution chamber and the AC power distribution chamber are relatively isolated from the filter reactor chamber.

23. The heat dissipation structure for the inverter according to claim 1, wherein the first cabinet is provided with a third heat exchanger, which has a first channel and a second channel for heat exchange, the first channel is in communication with the heat dissipation chamber, and the second channel is in communication with the electronic chamber; and/or,
the heat dissipation chamber and the electronic chamber are relatively isolated, and the first circulating air duct is a closed air duct; and/or,
the electronic chamber is further configured to house a control circuit section; and/or,
the first cabinet and the second cabinet are sequentially distributed in a vertical direction.

24. An inverter, **characterized by** comprising the heat dissipation structure for the inverter according to any one of claims 1 to 23.
